# EUROPÄISCHE PATENTSCHRIFT

(11) **EP 0 438 390 B1**
(45) Veröffentlichungstag und Bekanntmachung des Hinweises auf die Patenterteilung: **15.02.1995**
(21) Anmeldenummer: 88908691.4
(22) Anmeldetag: 12.10.1988
(51) Int. Cl.: C30B 15/10, C30B 15/30

(54) **VERFAHREN UND VORRICHTUNG ZUR ZÜCHTUNG VON KRISTALLEN NACH DER CZOCHRALSKI-METHODE**
PROCESS AND DEVICE FOR PULLING CRYSTALS ACCORDING TO THE CZOCHRALSKI METHOD
PROCEDE ET DISPOSITIF DE TIRAGE DE CRISTAUX SELON LA METHODE DE CZOCHRALSKI

(43) Veröffentlichungstag der Anmeldung: 31.07.1991
(73) Patentinhaber: SCHEEL, Hans J., Prof., CH-1009 Pully VD (CH)
(72) Erfinder: SCHEEL, Hans J., Prof., CH-1009 Pully VD (CH)
(74) Vertreter: Stoffregen, Hans-Herbert, Dr. Dipl.-Phys.
(86) Internationale Anmeldenummer: EP8800912
(87) Internationale Veröffentlichungsnummer: WO9004054

(56) Entgegenhaltungen:
- DE-A- 3 712 668
- PATENT ABSTRACTS OF JAPAN, vol.8, no.46 (C-212)(1483), 29 February 1984, & JP-A-58204895 (NIPPON DENSHIN DENWA KOSHA) 29 November 1983 see the whole document
- PATENT ABSTRACTS OF JAPAN, vol.5, no-136 (C-669)(808), 28 August 1981, &JP-A-5669298 (NIPPON DENKI K.K.) 10 June 1981
- PATENT ABSTRACTS OF JAPAN, vol. 7, no185 (C-181)(1330), 13 August 1983, & JP-A-58891097 (HITACHI SEISAKUSHO K.K.) 30 May 1983

## Beschreibung

Die Erfindung bezieht sich auf ein Verfahren und eine Vorrichtung zur Züchtung von Kristallen nach der Czochralski-Methode gemäß der Oberbegriffe der Ansprüche 1 und 8.

Nach der Czochralski-Methode werden Kristalle gezüchtet, indem der Kristall frei tragend aus einer in einen, Tiegel vorliegenden Schmelze unter genauer Kontrolle der Temperaturverhältnisse herausgezogen wird. Technisch hat die Czochralski-Methode die größte Bedeutung bei der Züchtung hochreiner Kristalle insbesondere für die Halbleitertechnik gewonnen.

Um Segregationseffekte zu verringern, um also eine konstante Zusammensetzung der Schmelze und damit der gezüchteten Kristalle anzustreben, wird nach der Zweikammertechnik ständig neue Schmelze aus einem Reservoir dem Bereich der Schmelze zugeführt, aus der der Kristall gezogen wird. Hierzu ist koaxial zu dem Kristall ein Hohlzylinder angeordnet, der sich von der Oberfläche der Schmelze bis zum Schmelztiegelboden erstreckt und mit diesem fest verbunden ist. Die Zuführung der Schmelze erfolgt durch in der Trennwand vorhandene Durchbrechungen. Zwar kann durch ein entsprechendes Zweikammersystem oder mit einem den ähnlichen Zweck erfüllenden Innentiegel möglicherweise das axiale Segregationsproblem verbessert werden, ohne daß jedoch das lokale Segregationsproblem (Striations-Problem) genügend beseitigt wird.

Zur Verringerung der Wachstumsstreifen sind andere Verfahren bekannt, zum Beispiel ein starkes Magnetfeld zur Reduktion der Konvektion. Entsprechende Maßnahmen sind jedoch aufwendig und zeigen unter anderem den Nachteil, daß gewisse elektrische Eigenschaften der Kristalle verschlechtert werden und die Schmelze "überhitzt" wird. Bei Galliumarsenidkristallen zeigt sich ferner der Nachteil, daß die Verteilung der Versetzungen inhomogener ist als in Kristallen, die ohne Magnetfeld hergestellt werden.

Aus Patent Abstracts of Japan, Bd. 8, Nr. 46 (C-212) (1483) (JP 58-204895) vom 29.2.1984 ist eine Vorrichtung bekannt, bei der in einem mit Schmelze gefüllten Außentiegel ein Innentiegel angeordnet ist, aus dem ein Kristall gezogen wird. Die Bodenfläche des Innentiegels weist ein Durchbrechen zum Durchtritt von Schmelze auf.

Ein Verfahren zum Züchten von Halbleiter-Einkristallen ist Patent Abstracts of Japan, Bd. 5, Nr. 136 (C-69) (808) (JP 56-69298) vom 28. August 1981 zu entnehmen, bei dem als Material für den Kristall Quarz in Form eines Käfigs benutzt wird, der den zu ziehenden Kristall umgibt und kontinuierlich in die Schmelze eingeführt wird.

Aufgabe der vorliegenden Erfindung ist es, ein Verfahren und eine Vorrichtung zur Verfügung zu stellen, bei der nicht nur das axiale Segregationsproblem weiter verringert werden kann, sondern auch das lokale und radiale Segregationsproblem reduziert wird. Zudem sollen Verbesserungen hinsichtlich der strukturellen Perfektion der gezogenen Kristalle sowie eine Verbesserung der Grenzfläche erzielt werden.

Die Aufgabe wird durch Maßnahmen gelöst, die den Kennzeichen der Ansprüche 1 und 8 zu entnehmen sind.

Durch die erfindungsgemäße Lehre wird durch die rotierende Trennwand ein von Schmelze gefüllter Ringraum unterhalb des Kristalles gebildet, der von der Restschmelze "abgetrennt" ist. In diesem inneren Schmelzraum wird die Konvektion -die natürliche und die erzwungene- unterdrückt, und zwar zunehmend mit steigender Rotation von Kristall und Trennwand. Vor allem wird die Ausbildung der sogenannten Taylor-Proudman-Zellen unterdrückt und der störende Einfluß der Marangoni-Konvektion starkt herabgesetzt.

Das nach dem Stand der Technik vorhandene achsiale Segregationsproblem wird dadurch weitgehend reduziert, daß -im Vergleich zur gesamten Schmelze- eine schnelle Einstellung einer Steady-State-Konzentration im Kristall erfolgt. Diese Konzentration bleibt über einen gewissen Zeitraum etwa konstant, bis sie gegen Prozeßende (bei einem Verteilungskoeffizienten kleiner als 1) ansteigt. Die Güte des gezogenen Kristalls nimmt hierdurch zu. Insbesondere wird der zuvor beschriebene Vorteil dadurch erzielt, daß bei einem kontinuierlichen Prozeß, bei dem laufend diejenige Materialmenge zugeführt wird, die als Kristall aus der Schmelze herausgezogen wird, sich ein Gleichgewicht so einstellt daß die Konzentration der Dotierung im Kristall der Dotierungskonzentration im Ausgangsstoff entspricht. Erst in der Schlußphase steigt dann die Dotierstoffkonzentration im Kristall entsprechend der zunehmenden Anreicherung.

Demzufolge wird mit einfach vorzunehmen den Maßnahmen die Ausbeute an Kristallmaterial mit quasi konstanter Dotierstoffkonzentration wesentlich erhöht, ohne daß die nach dem Stand der Technik aufwendigen Maßnahmen wie z.B. starke Magnetfelder und die damit verbundenen Nachteile in Kauf genommen werden müssen.

Durch die sich insbesondere aus einer Scherströmung ergebende Trennung des sich drehenden Schmelzbereichs, aus dem der Kristall gezogen wird, zu dem übrigen Material der Schmelze wird ein konvektiver Transport von Schmelzbereichen unterschiedlicher Temperatur an die wachsende Kristallfläche unterdrückt, so daß Fluktuationen der Wachstumgeschwindigkeiten weitgehend vermieden werden. Hierdurch werden weitgehend achsiale und radiale Inhomogenitäten vermindert. Demzufolge sind mit dem erfindungsgemäßen Verfahren hergestellte Kristalle insbesondere für elektronische und optoelektronische Bauelemente mit Eigenschaften, die sich in engen Toleranzen halten, und für integrierte Schaltkreise, die eine hohe Integrationsdichte aufweisen, geeignet.

Durch den von der Trennwand begrenzten rotierenden Ringraum werden des weiteren Vibrationen und Oberflächenwellen auf der Schmelze, aus der der Kristall gezogen wird, sowie thermische Unsymmetrien um den wachsenden Kristall vermieden, die sonst ebenfalls zu Striations-Problemen führen. Auch werden kleine Niveauschwankungen der Schmelze, die sich aus der stückweisen Materialzufuhr beim kontinuierlichen Verfahren ergeben können, durch die Trennung mit Trennwand und durch den rotierenden zentralen Bereich der Schmelze gedämpft.

Sofern nach dem erfindungsgemäßen Verfahren Silizium-Kristalle gezogen werden sollen, wird das bekannte SiO-Problem reduziert; denn bekanntlich löst sich SiO₂ aus dem Tiegelmaterial SiO₂ auf und wird teils als Sauerstoff eingebaut oder als SiO verdampft. Die Sauerstoffkonzentration sollte in den Si-Kristallen je nach Anwendung in engen Grenzen gehalten werden, z.B. 16 ± 1 ppm. Durch das Verhältnis der Schmelzvolumina ("Ringvolumen", Restvolumen der Schmelze) zur Wachstumsgeschwindigkeit wird die "Verweilzeit" des Siliziums im Tiegel bestimmt, und die geometrischen Verhältnisse sowie die Rotationszahldifferenz zwischen Kristall/Ring einerseits und Tiegel andererseits bestimmen (durch die Taylor- und Scherströmungen) die Auflösungsgeschwindigkeit des SiO₂-Tiegels. Durch optimale Einstellung dieser Verhältnisse und Parameter lassen sich eine bestimmte Sauerstoffkonzentration im Siliziumkristall sowie eine weitgehende achsiale Homogenität der Sauerstoffkonzentration erreichen. Durch kurze Verweilzeiten - im Vergleich zur konventionellen Praxis - sind auch relativ kleine Sauerstoffkonzentrationen erreicht worden.

Das erfindungsgemäße Verfahren ist überall dort einzusetzen, wo die Czochralski-Methode zum Züchten von Kristallen wie z.B. Si, GaAs, Ge, InP, CdTe, Wismutgermanat, Granate, titandotierte Saphire oder Rubine Verwendung findet und wo Homogenität und die Ausbeute an homogenem Kristallanteil von Bedeutung ist.

Weitere Einzelheiten der Erfindung ergeben sich aus den Ansprüchen und den diesen zu entnehmenden Merkmalen -für sich und/oder in Kombination-.

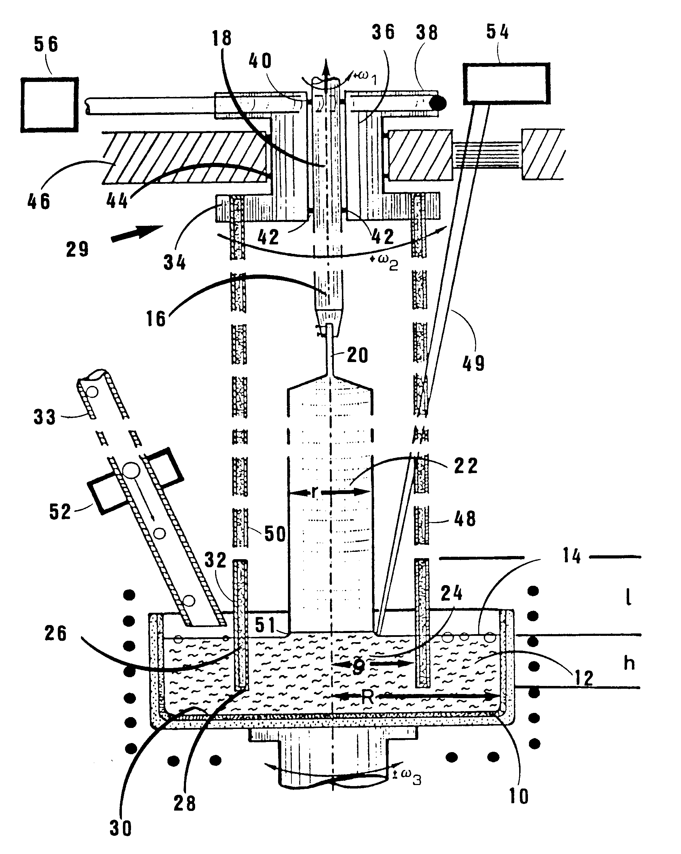

Die Erfindung wird nachstehend an Hand eines in der Zeichnung dargestellten bevorzugten Ausführungsbeispiels näher erläutert, wodurch sich weitere Einzelheiten, Vorteile und Merkmale ergeben.

In der einzigen Figur ist in rein schematischer Darstellung eine erfindungsgemäße Vorrichtung zum Züchten von Kristallen nach der Czochralski-Methode dargestellt. Die Vorrichtung befindet sich in einem nicht näher bezeichneten wassergekühlten Stahlkessel und umfaßt einen Schmelztiegel (10), in dem sich eine Schmelze (12) befindet. Oberhalb der Oberfläche (14) der Schmelze (12) ist eine Kristallhalterung (16) angeordnet, die um ihre Längsachse (18) drehbar und entsprechend der Kristallwachstumsgeschwindigkeit achsial verschiebbar ist. An der Kristallhalterung (16) ist ein Keimkristall (20) gewünschter Orientierung angeordnet, auf den ein Kristall (22) aus der Schmelze (12) wächst. Erfindungsgemäß ist koaxial zur Kristallhalterung (16) ein Ringraum (24) in der Schmelze (12) angeordnet, aus dem der Kristall (22) wächst. Dieser Ringraum (24) ist außerdem gleichsinnig zu der Kristallhalterung (16) rotierbar. Hierzu wird der Ringraum (24) von einer Trennwand (26) in Form eines Hohlzylinders umgeben, der von einer Halteeinrichtung (29) ausgeht. Die Trennwand (26) ist mit ihrem unteren Ende (28) zu dem Boden des Schmelztiegels (30) beabstandet. Ferner ragt das obere Ende (32) aus der Schmelze (12) bzw. (24) heraus, durchdringt demzufolge die Oberfläche (14). In den Bereich zwischen der Trennwand (26) und dem Schmelztiegel (10) wird über eine Zuführung (33) kontinuierlich Material zugeführt, und zwar in einem Umfang, der der Materialmenge des aus der Schmelze (24) wachsenden Kristalls (22) entspricht. Hierdurch wird erreicht, daß das Niveau der Oberfläche (14) auf einem konstanten Wert gehalten ist, so daß die Höhe h der in der Schmelze (12) bzw. (24) eintauchenden Trennwand (26) gleichbleibend ist. Das durch die Zuführung (33) in den Tiegel (10) gelangende Material kann z.B. mit einem optischen System (52) erfaßt oder gezählt werden, um den Materialausgleich kontrolliert konstant zu halten.

Erwähntermaßen ist die Trennwand (26) mit der Halteeinrichtung (29) verbunden, die im Ausführungsbeispiel aus einem Scheibenelement (34), einer Hülse (36) und einer Antriebsscheibe (38) besteht, die mit einem Antrieb (56) verbunden ist. Koaxial durch die Hülse (36) und über Präzisionslager (40), (42) wie z.B. Magnet- oder Luftlager ist die Halterung (16) geführt, die zu der Hülse (36) dreh- und anheb- bzw. absenkbar ist. Die Hülse (36) selbst wird ebenfalls über rotierbare Präzisions-Lager (44) von einer Befestigung (46), eines Teils des nicht gezeigten Stahlkessels, aufgenommen. Die Verbindung zwischen der Trennwand (26) und dem Scheibenelement (34) erfolgt über einzelne Stäbe, die in der Zeichnung mit den Bezugszeichen (48) und (50) versehen sind. Demzufolge ist der Bereich zwischen der Trennwand (26) und dem Scheibenelement (34) im wesentlichen frei zugänglich, so daß der Schmelzmeniskus (51) am Kristall (22) optisch durch z.B. ein Laserreflektionssystem (54) kontrolliert werden kann (durch Bezugszeichen (49) angedeutet). Durch die Länge l des aus der Schmelze herausragenden Ring-Zylinders (32) können die Temperaturverhältnisse im oberen Schmelzbereich und im unteren Kristallbereich so beeinflußt werden, daß bei einer wirtschaftlichen Kristallziehgeschwindigkeit die Form der Kristall-Schmelz-Grenzflache beeinflußt und die strukturelle Perfektion des Kristalls (z.B. GaAs) verbessert werden können.

Die Drehbewegung der Kristallhalterung (16) zu der der Trennwand (26) ist relativ einstellbar, wobei jedoch der Drehsinn gleich ist.

Bei gegensinniger Rotation von Kristall und Trennwand wird zwar die Konvektion im Schmelzbereich unterhalb des Kristalls nicht unterdrückt, sondern verstärkt. Dies kann auch zur Unterdrückung der Striations verwendet werden und hat damit gewisse Vorteile, hilft aber nicht zur Verringerung des achsialen Segregationsproblems.

Durch die erfindungsgemäße Vorrichtung lassen sich gewünschte Kristalle, die nach der Czochralski-Methode hergestellt werden können, züchten, wobei die nach dem Stand der Technik auftretenden Segregationsprobleme reduziert werden.

Außerdem werden Strukturverluste vermindert. Verlieren nach dem Stand der Technik hergestellte Kristalle nach Erreichen kritischer Kristalllängen ihre kristalline Perfektion, d.h. es bilden sich z.B. in einem vorher versetzungsfreien Silizium-Kristall Versetzungen oder im Galliumarsenid Verzwillingungen, die dann bei Fortsetzung des Ziehversuches zum Verlust der strukturellen Perfektion führen, so sind diese bei den Kristallen, die nach dem erfindungsgemäßen Verfahren bzw. mit der erfindungsgemäßen Vorrichtung hergestellt werden, erst in einer späteren Wachstumsphase festzustellen.

Ein zusätzlicher Vorteil ist die Tatsache, daß der Tiegel nicht gedreht werden muß. Der Schmelzanteil im Ring soll nicht stark durchmischt werden, und der äußere Schmelzanteil soll homogenisiert werden. Dies wird durch einen stehenden Tiegel und dem rotierenden Trennwand-/Kristall-System in einem ausreichenden Maße erreicht, während beim üblichen Czochralski-Verfahren eine Tiegeldrehung normalerweise verwendet wird.

Der stationäre Tiegel ist insbesondere bei Hochdruck-Czochralski-Verfahren und bei Heißwand-Verfahren (z.B. für GaAs) vorteilhaft, weil die Kristallziehanlage damit wesentlich vereinfacht werden kann.

Auch kann der Tiegel bei kontinuierlichen Ziehverfahren von der runden Form abweichen, was z. B. die Materialzufuhr vereinfachen kann.

Die Erfindung wurde für das kontinuierliche Kristallziehverfahren mit Materialzufuhr beschrieben, gilt aber sinngemäß ach für den klassischen Batch-Prozeß, bei dem das vorhandene Schmelzgut als Kristall gezogen wird, ohne daß Material nachgegeben wird. Dabei muß nur durch relative vertikale Bewegung zwischen Trennwandhalterung und Tiegel eine Minimaldistanz von 0,5 mm zwischen diesen Komponenten erhalten bleiben.

Der erfindungsgemäße Verfahrensablauf ist nun der folgende:
Für einen Ziehversuch von einem Silizium-Kristall von 11 cm Durchmesser wird der Quarzglastiegel, der sich in einer Graphitform befinde und der 33 cm Innendurchmesser und 14 cm Höhe hat, mit 20 kg polykristallinem Silizium gefüllt Nach Schließen des Stahlkessels, Evakuieren und Argoneinlaß mit etwa 800 Liter pro Stunde, so daß sich ein Druck von etwa 1333 Pa (10 Torr) einstellt, wird das Silizium zum Schmelzen gebracht. Dann wird der Tiegel in die optimale Stellung angehoben, so daß der Trennwandring in die Schmelze eintaucht. Dabei muß durch Überhitzen der Schmelze eine vollständige Verfestigung der Schmelze verhindert werden.

Nach Erreichung der optimalen Schmelztemperatur und eines thermischen Quasi-Gleichgewichts wird der am Kristallhalter befestigte Keimkristall eingetaucht und nach dem üblichen Verfahren gezogen und verbreitert, bis der Solldurchmesser erreicht worden ist. Die Materialzufuhr wird dann eingeschaltet und auf den Erfahrungswert eingestellt, der bei einer Kristallziehgeschwindigkeit von 11 cm pro Stunde die konstante Schmelzhöhe einzuhalten erlaubt. Dabei wird der Tiegel nicht gedreht, während sowohl Kristall als auch der Trennring mit 26 RPM konstant gleichsinnig gedreht werden. Die Schmelztemperatur wird konstant gehalten, wobei die Heizleistung anfänglich noch nachgeregelt werden muß, bis das thermische Gleichgewicht erreicht worden ist.

Nach Erreichen einer Kristall-Länge von 1,4 m wird der Prozeß auf eine dem Fachmann bekannte Weise beendet, wobei die Trennwand von der Schmelze entfernt wird.

## Patentansprüche

1. Verfahren zur Züchtung von Kristallen (22) nach der Czochralski-Methode mit in einem Tiegel (10) vorhandener Schmelze (12), einer Kristallhalterung (16) für einen aus der Schmelze zu ziehenden Kristall (22) und einem koaxial zu der sich drehenden und anhebbaren Kristallhalterung angeordneten, sich von der Oberfläche der Schmelze in diese hinein erstreckenden, für das Wachstum des Kristalls benötigte Schmelze begrenzenden, zum Boden des Tiegels beabstandeten sowie drehbaren Trennelement (26) mit einer einen Hohlzylinderraum umgebenden Trennwand,
**dadurch gekennzeichnet**,
daß die zum Wachstum des Kristalls benötigte Schmelze über den gesamten Querschnitt des allein von der Trennwand gebildeten Trennelementes (26) umgebenden Hohlzylinderraums strömt, wobei die Trennwand gleichsinnig zu der Kristallhalterung (16) mit einer Rotationsgeschwindigkeit in der Schmelze (12) gedreht wird, die von der der Kristallhalterung (16) abweicht oder mit dieser übereinstimmt,

2. Verfahren nach Anspruch 1,
**dadurch gekennzeichnet**,
daß die Rotationsgeschwindigkeit voll der Kristallhalterung (16) und/oder der Trennwand (26) während der Züchtung des Kristalls variiert wird.

3. Verfahren nach Anspruch 1 oder 2,
**dadurch gekennzeichnet**,
daß die Drehzahl ω₁ der Kristallhalterung (16) mindestens 2 RPM, maximal 105 RPM beträgt.

4. Verfahren nach zumindest einem der vorhergehenden Ansprüche,
**dadurch gekennzeichnet**,
daß die Drehzahl ω₂ der Trennwand (26) mindestens 2 RPM, maximal 105 RPM beträgt.

5. Verfahren nach zumindest einem der vorhergehenden Ansprüche,
**dadurch gekennzeichnet**,
daß das der Schmelze (12) zugeführte Material optisch erfaßt wird.

6. Verfahren nach zumindest einem der vorhergehenden Ansprüche,
**dadurch gekennzeichnet**,
daß der Tiegel gleich- oder gegensinnig zu der Kristallhalterung und der Trennwand gedreht wird.

7. Verfahren nach zumindest einem der vorhergehenden Ansprüche,
**dadurch gekennzeichnet**,
daß zur Erzielung eines konstanten Schmelzeniveaus innerhalb des Tiegels in zwischen Tiegelinnenwandung und der Trennwand gebildetem Raum Material kontrolliert in einem Umfang zugeführt wird, der dem als Kristall aus der Schmelze herausgezogenen Material entspricht.

8. Vorrichtung zur Züchtung von Kristallen (22) nach der Czochralski-Methode mit in einem Tiegel (10) vorhandener Schmelze (12), einer Kristallhalterung (16) für einen aus der Schmelze zu ziehenden Kristall (22), die mittels eines Antriebs (56) drehbar und in Abhängigkeit von der Kristallwachstumsgeschwindigkeit anhebbar ist, sowie einem koaxial zu der Kristallhalterung angeordneten und zum Boden des Tiegels beabstandeten Trennelement (26) mit einer einen Hohlzylinderraum umgebenden gleichsinnig uni den Kristall drehbaren Trennwand, die die das Wachstum des Kristalls ermöglichende Schmelze umgibt,
**dadurch gekennzeichnet**,
daß das Trennelement (26) allein durch die gleichsinnig mit dem Kristall drehbare Trennwand gebildet ist, daß die Trennwand die Form eines bodenseitig freien und zumindest im Bereich der Schmelze umfangsseitig geschlossenen Hohlzylinders aufweist und daß der in die Schmelze (12) eintauchende Bereich während des Wachstums des Kristalls (22) weitgehend unverändert ist.

9. Vorrichtung nach Anspruch 8,
**dadurch gekennzeichnet**,
daß die bodenseitig offene Trennwand über stabförmige Elemente (48, 50) mit einem im Abstand zu der Oberfläche (14) der Schmelze (12, 24) angeordneten Scheibenelement (34) verbunden ist, das von einer von der Kristallhalterung (16) durchsetzten Hülse (36) ausgeht, die mit dem Dreh-Antrieb wechselwirkt.

10. Vorrichtung nach Anspruch 8 oder 9,
**dadurch gekennzeichnet**,
daß die Trennwand (26) seitlich von dem Tiegel (10) oder unterhalb des Tiegels gelagert ist.

11. Vorrichtung nach zumindest einem der Ansprüche 8 bis 10,
**dadurch gekennzeichnet**,
daß die Höhe h der Schmelze innerhalb des Trennelementes (26) 0,1 ≦ h ≦ 10 cm bei einem Radius r des Kristalls (22) mit 1 cm ≦ r ≦ 12 cm und einem Radius ρ des von dem Trennelement umgebenen Hohlzylinders (24) mit 1,5 ≦ ρ ≦ 18 cm und einem Radius R des Tiegels (10) mit 2 ≦ R ≦ 32 cm beträgt.

## Claims

1. Process for growing crystals (22) by the Czochralski method with melt (12) present in a crucible (10), a crystal holder (16) for the crystal (22) to be pulled from the melt and a separation element (26) disposed coaxially with the rotating and raisable crystal holer and extending from the surface of the melt into the melt, defining the melt required for the growth of the crystal, and being spaced apart from the bottom of the crucible and rotatable, the separation element having a separation wall surrounding a hollow cylindrical chamber,
**characterized in that**
the melt required for the growth of the crystal flows over the entire cross section of the hollow cylindrical chamber surrounding the separation element (26) formed solely by the separation wall, the separation wall being rotated in the melt (12) in same direction to the crystal holder (16) at a rotational speed that differs from or is corresponding with that of the crystal holder (16).

2. Process as defined in claim 1,
**characterized in that**
the rotational speed of the crystal holder (16) and/or separation wall (26) is varied during the growth of the crystal.

3. Process as defined in claim 1 or claim 2,
**characterized in that**
the speed ω₁ of the crystal holder (16) is at least 2 rpm and a maximum of 105 rpm.

4. Process as defined in at least one of the preceding claims,
**characterized in that**
the speed ω₂ of the separation wall (26) is at least 2 rpm and a maximum of 105 rpm.

5. Process as defined in at least one of the preceding claims,
**characterized in that**
the material supplied to the melt (12) is optically detectable.

6. Process as defined in at least one of the preceding claims,
**characterized in that**
the crucible is rotated in the same direction or the opposite direction with respect to the crystal holder and the separation wall.

7. Process as defined in at least one of the preceding claims,
**characterized in that**
to attain a constant melt level inside the crucible in the space formed between the inner crucible wall and the separation wall, material is supplied in monitored fashion to an extent that is equivalent to the material removed from the melt in the form of a crystal.

8. Equipment for the growth of crystals (22) by the Czochralski method with melt (12) present in a crucible (10), a crystal holder (16) for a crystal (22) to be pulled from the melt, which holder is rotatable by means of a drive mechanism (56) and raisable as a function of the crystal growth speed, and a separation element (26) disposed coaxially with the crystal holder and spaced apart from the bottom of the crucible, having a separation wall surrounding a hollow-cylindrical chamber, which wall surrounds the melt that enables the growth of the crystal,
**characterized in that**
the separation element (26) is formed by the separation wall alone, which is rotatable in the same direction with the crystal, the separation wall has the form of a bottomly free and at least in the region of the melt peripheraly closed hollow cylinder, the region of which that dips into the melt is largely unvaried during the growth of the crystal (22).

9. Equipment as defined in claim 8,
**characterized in that**
the bottomly open separation wall is joined via rod-shaped elements (48, 50) to a disk element (34) disposed spaced apart from the surface (14) of the melt (12, 24), which disk element begins at a sheath (36) penetrated by the crystal holder (16), which sheath interacts with the rotary drive mechanism.

10. Equipment as defined in claim 8 or claim 9,
**characterized in that**
the separation wall (26) is supported laterally of the crucible (10) or underneath the crucible.

11. Equipment as defined in at least one of the claims 8 to 10,
**characterized in that**
the heigh (h) of the melt inside the separation element (26) amounts to 0.1 ≦ h ≦ 10 cm for a radius r of the crystal (22), where 1 cm ≦ r ≦ 12 cm and a radius ρ of the hollow cylinder (24) surrounded by the separation element, where 1.5 ≦ ρ ≦ 18 cm and for a radius R of the crucible (10) where 2 ≦ R ≦ 32 cm.

## Revendications

1. Procédé de tirage de cristaux (22) selon la méthode de Czochralski avec une fonte (12) disponible dans un creuset (10), un support (16) pour un cristal (22) à tirer de la fonte et un élément de séparation (26) disposé coaxialement par rapport au support de cristal rotatif et soulevable, s'étendant à partir de la surface de la fonte à l'intérieur de cette dernière, limitant la fonte nécessaire à la croissance du cristal, avec un certain écart du fond du creuset et rotatif avec une paroi de séparation entourant un espace cylindrique creux,
**caractérisé en ce que**
la fonte nécessaire à la croissance du cristal coule par dessus toute la section de l'espace cylindrique creux entouré uniquement par l'élément de séparation (26) formé par la paroi de séparation, la paroi de séparation étant tournée dans le même sens que le support de cristal (16) avec une vitesse de rotation dans la fonte (12) déviant de celle du support (16) ou concordant avec elle.

2. Procédé selon la revendication 1,
**caractérisé en ce que**
la vitesse de rotation du support de cristal (16) et/ou de la paroi de séparation (26) est variée pendant le tirage du cristal.

3. Procédé selon la revendication 1 ou 2,
**caractérisé en ce que**
la vitesse ω₁ du support du cristal (16) est d'au moins 2 RPM, au maximum 105 RPM.

4. Procédé selon au moins l'une des revendications précédentes,
**caractérisé en ce que**
la vitesse ω₂ de la paroi de séparation (26) est d'au moins 2 RPM, au maximum 105 RPM.

5. Procédé selon au moins l'une des revendications précédentes,
**caractérisé en ce que**
le matériau amené à la fonte (12) est détecté optiquement.

6. Procédé selon au moins l'une des revendications précédentes,
**caractérisé en ce que**
le creuset est tourné dans le même sens ou dans le sens opposé par rapport à celui du support du cristal et de la paroi de séparation.

7. Procédé selon au moins l'une des revendications précédentes,
**caractérisé en ce que**
pour obtenir un niveau de fonte constant à l'intérieur du creuset, du matériau est amené de façon contrôlée entre la paroi intérieure du creuset et l'espace formée par la paroi de séparation sous forme d'un volume correspondant à celui du matériau tiré comme cristal de la fonte.

8. Dispositif de tirage de cristaux (22) selon la méthode de Czochralski avec une fonte (12) disponible dans un creuset (10), un support (16) pour un cristal (22) à tirer de la fonte, rotatif au moyen d'un entraînement (56) et soulevable en fonction de la vitesse de croissance du cristal, ainsi qu'avec un élément de séparation (26) disposé coaxialement par rapport au support du cristal et avec un certain écart du fond du creuset, avec une paroi de séparation entourant un espace cylindrique creux tournant dans le même sens autour du cristal, cette paroi entourant la fonte permettant la croissance du cristal,
**caractérisé en ce que**
l'élément de séparation (26) est formé uniquement par la paroi de séparation tournant dans le même sens que le cristal, que la paroi de séparation présente la forme d'un cylindre creux avec un certain écart du fond et fermé sur la périphérie au moins dans la zone de la fonts et que la zone immergée dans la fonte (12) est presque invariable pendant la croissance du cristal (22).

9. Dispositif selon la revendication 8,
**caractérisé en ce que**
la paroi de séparation ouverte dans le fond est reliée à travers des éléments en forme de barre (48, 50) à un disque (34), disposé à un certain écart de la surface (14) de la fonte (12, 24), ce disque partant d'une douille (36) traversée par le support du cristal (16) et agissant interactivement avec l'entraînement de rotation.

10. Dispositif selon la revendication 8 ou 9,
**caractérisé en ce que**
la paroi de séparation (26) est logée au côté du creuset (10) ou en-dessous du creuset.

11. Dispositif selon su moins l'une des revendications 8 à 10,
**caractérisé en ce que**
la hauteur h de la fonte a l'intérieur de l'élément de séparation (26) s'élève à 0,1 ≦ h ≦ 10 cm avec un rayon r du cristal (22) de 1 cm ≦ r ≦ 12 cm et un rayon ρ du cylindre creux (24) entourant l'élément de séparation de 1,5 ≦ ρ ≦ 18 cm et un rayon R du creuset (10) de 2 < R < 32 cm.
